# EUROPEAN PATENT APPLICATION

(11) **EP 2 404 947 A1**
(43) Date of publication of application: **11.01.2012**
(21) Application number: 11173221.0
(22) Date of filing: 08.07.2011
(51) Int. Cl.: C08G 59/62, C08L 63/00, C08J 3/24

(54) **Method for manufacturing cured product of thermosetting resin composition and cured product obtained thereby**

(30) Priority: 08.07.2010 JP 2010156234
(71) Applicant: NITTO DENKO CORPORATION, Osaka 567 (JP)
(72) Inventor: Yamamoto, Mizuki, Ibaraki-shi, Osaka 567-8680 (JP)
(74) Representative: Grünecker, Kinkeldey, Stockmair & Schwanhäusser

(57) **Abstract**

The present invention relates to a method for producing a cured product of a thermosetting resin composition, the method including: heating a thermosetting resin composition including the following ingredients (A) to (C) at a temperature of 100 to 200°C for 1 to 60 minutes; and then further heating the thermosetting resin composition at a temperature of 220 to 350°C for 10 to 6,000 minutes, thereby curing the thermosetting resin composition: (A) an allylated phenol resin; (B) an epoxy resin; and (C) a curing accelerator.

## Description

### FIELD OF THE INVENTION

The present invention relates to a method for producing a cured product of a thermosetting resin composition which is used for an encapsulating material requiring high heat resistance in a power device or the like and is excellent in long-term heat resistance and heat cycle resistance, and a cured product obtained thereby.

### BACKGROUND OF THE INVENTION

Usually, semiconductor devices have hitherto been fabricated by encapsulating semiconductor elements such as transistors, ICs and LSIs with ceramic packages, plastic packages or the like. The former ceramic packages have excellent durability under high temperature and high humidity, because their constituent materials themselves have heat resistance and also have excellent humidity resistance, and further have excellent mechanical strength. Accordingly, highly reliable encapsulation is possible. However, the above ceramic packages have problems that the constituent materials are relatively expensive and that the packages are poor in mass productivity. In recent years, therefore, resin encapsulation with the latter plastic packages has become mainstream. In the resin encapsulation with the above plastic packages, epoxy resin compositions have hitherto been used by utilizing their property of excellent heat resistance, and achieve satisfactory results. As such an epoxy resin composition for encapsulating the semiconductor elements, there has been generally used a composition including an epoxy resin as a main material, a phenol resin as a curing agent, an amine-based compound as a curing accelerator, and other optional ingredients such as a rubber ingredient as an elasticity imparting agent and a silica powder as an inorganic filler, particularly as a composition excellent in terms of encapsulating workability and the like at the time of transfer molding.

On the other hand, some insulating materials such as a semiconductor encapsulating material including an allyl group-containing phenol resin have hitherto been proposed. However, the actual situation is that no material sufficiently satisfying heat resistance is obtained yet. The above insulating materials such as a semiconductor encapsulating material including an allyl group-containing phenol resin include, for example, one intending to improve adhesiveness (see Patent Document 1), one improving moisture absorption resistance (see Patent Document 2), one decreasing the melt viscosity of a thermosetting resin composition (see Patent Document 3), one intending to improve laser marking properties (see Patent Document 4), one having low-temperature expansion (see Patent Document 5) and the like. These are satisfactory in respective characteristics, but do not sufficiently satisfy heat resistance. Further, as an example of improving heat resistance, there is proposed a thermosetting resin composition including an allyl group-containing phenol resin and a bismaleimide resin (see Patent Document 6). However, the reactivity of the bismaleimide resin-containing thermosetting resin composition is poor, compared to an epoxy resin-phenol resin curing reaction which is generally used in the encapsulating materials and the like at the time of molding, and has a problem of poor workability. Furthermore, there are ones improving the glass transition temperature by using thermosetting resin compositions each including an allyl group-containing phenol resin and a epoxy resin (see Patent Documents 7 to 10). However, the post-curing temperature of these is 200°C or less in all cases, so that the above allyl group is not cured, not leading to improvement in heat resistance. The allyl group requires a high temperature exceeding 200°C for thermal curing and is very low in reactivity. Accordingly, the actual situation is that it has not been studied to improve heat resistance by positively curing the allyl group.

| | |
|---|---|
| Patent Document 1: | JP-A-8-306828 |
| Patent Document 2: | JP-A-7-145300 |
| Patent Document 3: | JP-A-9-31167 |
| Patent Document 4: | JP-A-4-249526 |
| Patent Document 5: | JP-A-6-263841 |
| Patent Document 6: | JP-A-3-237126 |
| Patent Document 7: | JP-A-2001-11161 |
| Patent Document 8: | JP-A-5-132539 |
| Patent Document 9: | JP-A-5-320317 |
| Patent Document 10: | JP-A-6-136093 |

### SUMMARY OF THE INVENTION

By the way, power devices such as transistors, diodes and thyristors are used as semiconductor devices for performing high power control or the like in major appliances or industrial instruments. In such power devices, replacement of Si elements to SiC elements or GaN elements has been studied, in order to substantially decrease the loss in electric power converters. It becomes possible to increase the capacity by the replacement to the SiC elements or the GaN elements. As a result, it is considered that the semiconductor elements are exposed to high voltage to cause an exothermic temperature thereof as extremely high as 200 to 250°C. There is therefore a possibility that when the semiconductor elements have poor heat resistance, breakage of the packages or the semiconductor elements becomes liable to occur.

As a method for improving heat resistance of the encapsulating resin, it is also considered to add silicone oil or a rubber ingredient into the encapsulating resin composition. However, there is a concern that these additive ingredients seep into an interface between a frame and the encapsulating resin to pose a problem of decreasing adhesive force in the interface.

On the other hand, as molding methods for encapsulating semiconductor elements, there are various molding methods such as screen printing or dispense molding using a liquid encapsulating resin, and transfer molding, sheet molding or compression molding using a solid encapsulating resin. In each case where the molding methods are used, fluidity and curability are required for thermosetting resin compositions.

Among the thermosetting resin compositions, there are also high heat-resistant thermosetting resin compositions. However, it is considered that such thermosetting resin compositions are deteriorated in formability by poor curability due to a slow reaction rate thereof. Further, some thermosetting resin compositions produce by-products such as gas at the time of thermal curing reaction. In the case where such thermosetting resin compositions are used for semiconductor encapsulating material applications, when the by-products such as gas are produced during molding, voids and the like are formed in the encapsulating resins caused by the gas, which poses a problem of decreasing reliability, such as the occurrence of failures of devices.

The invention has been made in view of such a situation, and an object thereof is to provide a method for producing a cured product of a thermosetting resin composition having high heat resistance, which has high glass transition temperature, is excellent in long-term heat resistance and can improve reliability as a device, for example, in insulating applications in electronic parts requiring high heat resistance, such as a power device; and a cured product obtained thereby.

Namely, the present invention relates to the following items 1 to 6.
1. A method for producing a cured product of a thermosetting resin composition, the method including: heating a thermosetting resin composition including the following ingredients (A) to (C) at a temperature of 100 to 200°C for 1 to 60 minutes; and then further heating the thermosetting resin composition at a temperature of 220 to 350°C for 10 to 6,000 minutes, thereby curing the thermosetting resin composition:
   (A) an allylated phenol resin;
   (B) an epoxy resin; and
   (C) a curing accelerator.
2. The method for producing a cured product of a thermosetting resin composition according to item 1, in which the allylated phenol resin as ingredient (A) contains the following structural unit (1): 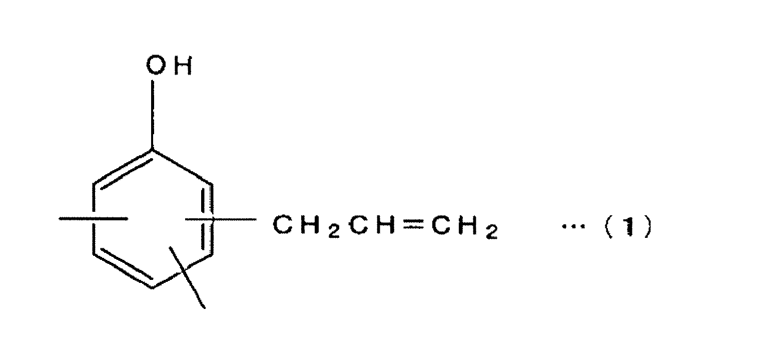
3. The method for producing a cured product of a thermosetting resin composition according to item 2, in which the allylated phenol resin as ingredient (A) contains the following structural unit (2), in addition to the structural unit (1): 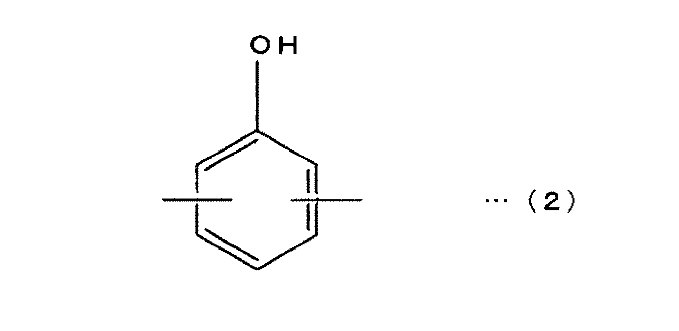
4. The method for producing a cured product of a thermosetting resin composition according to any one of items 1 to 3, in which the allylated phenol resin as ingredient (A) has an allyl group equivalent of 100 to 3,000 (g/eq.).
5. The method for producing a cured product of a thermosetting resin composition according to any one of items 1 to 4, in which the allylated phenol resin as ingredient (A) has a phenolic hydroxyl group equivalent of 100 to 3,000 (g/eq.).

6. A cured product obtained by the method for producing a cured product of a thermosetting resin composition according to any one of items 1 to 5.

The present inventors have made intensive studies in order to solve the above problems. As a result, when the cured product is prepared by using the thermosetting resin composition including the above allylated phenol resin (ingredient (A)), the epoxy resin (ingredient (B)) and the curing accelerator (ingredient (C)), first heating this composition at a temperature of 100 to 200°C for 1 to 60 minutes, and thereafter heating it at a temperature of 220 to 350°C for 10 to 6,000 minutes, it has been found that the resulting cured product can sufficiently satisfy long-term heat resistance of, for example, 200 to 250°C or more, and can be used for applications requiring high heat resistance, such as a power device. Thus, the invention has been reached.

The above allylated phenol resin (ingredient (A)) has phenolic hydroxyl groups, and the epoxy resin (ingredient (B)) has epoxy groups. Accordingly, it is considered that release of the thermally cured thermosetting resin composition from a mold becomes easy by reacting them by heating at a temperature of 100 to 200°C described above to improve productivity in a resin encapsulation molding process using a semiconductor encapsulating material, which is represented by transfer molding. Further, the above allylated phenol resin (ingredient (A)) can be post-cured under a temperature condition of 220°C or more, because it has allyl groups. That is to say, it is considered that when a part of the allyl groups are thermally cured under a temperature condition of 220°C or more, the glass transition temperature (Tg) of the cured product is improved. Further, when crosslinked portions formed by the epoxy groups and the phenolic hydroxyl groups are cleaved, for example, by exposure to an extremely high use environment temperature of the power device, there is a concern that the cured product of the thermosetting resin composition becomes soft. However, the allyl groups of the allylated phenol resin (ingredient (A)), which do not take part in the above curing, are presumed to gradually react by high temperature to form strong bonds.

Then, the present inventors have made a series of studies, and as a result, have found that the cured product obtained using the thermosetting resin composition including the above ingredient (A), ingredient (B) and ingredient (C) under the above specific heat curing conditions can sufficiently satisfy long-term heat resistance at a temperature of 200 to 250°C or more and can be used for applications requiring high heat resistance, such as the power device.

As described above, the invention relates to a method for curing the above thermosetting resin composition by using the thermosetting resin composition including the above allylated phenol resin (ingredient (A)), the epoxy resin (ingredient (B)) and the curing accelerator (ingredient (C)), heating this composition at a temperature of 100 to 200°C for 1 to 60 minutes, and further heating it at a temperature of 220 to 350°C for 10 to 6,000 minutes. The cured product thus obtained can be subjected to screen printing or dispense molding using a liquid encapsulating resin, or transfer molding, sheet molding, compression molding or the like to form a semiconductor device. The resulting semiconductor device is difficult to be decomposed even when exposed under a high-temperature atmosphere such as 200 to 250°C for a long period of time. Thus, excellent long-term heat resistance is imparted thereto.

Then, when the allyl group equivalent of the above allylated phenol resin (ingredient (A)) is from 100 to 3,000 (g/eq.), the cured product having more excellent heat resistance is obtained.

Further, when the phenolic hydroxy group equivalent of the above allylated phenol resin (ingredient (A)) is from 100 to 3,000 (g/eq.), the cured product having more excellent heat resistance and curability is obtained.

### BRIEF DESCRIPTION OF THE DRAWINGS

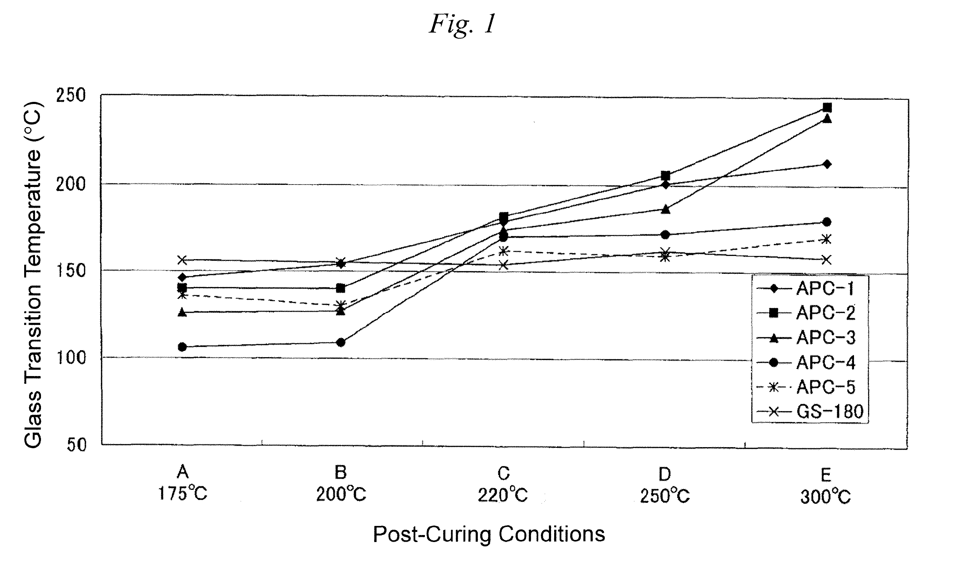

Fig. 1 is a post-curing conditions-glass transition temperature (°C) curve graph showing changes in glass transition temperature depending on post-curing conditions of cured products of allylated phenol resins or a phenol resin and an epoxy resin.

### DETAILED DESCRIPTION OF THE INVENTION

The thermosetting resin composition used in the invention is obtained using an allylated phenol resin (ingredient (A)), an epoxy resin (ingredient (B)) and a curing accelerator (ingredient (C)), and usually served as an encapsulating material in the form of liquid, powder or a tablet formed through tabletting from the powder.

The above allylated phenol resin (ingredient (A)) is, for example, a phenol resin having the following structural unit (1):

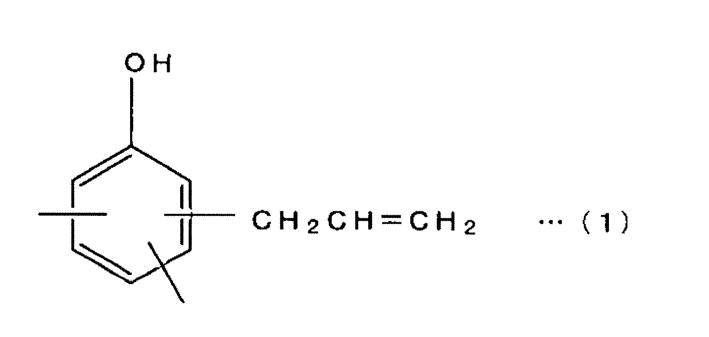

Further, the above allylated phenol resin (ingredient (A)) may contain the above structural unit (1) and the following structural unit (2):

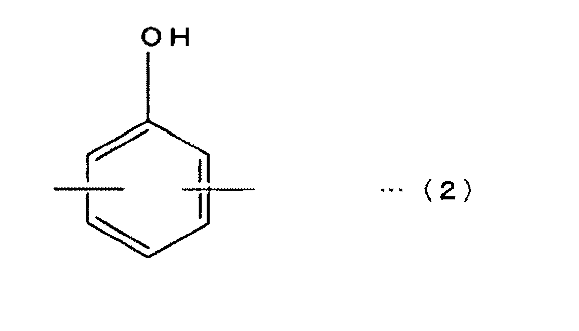

Then, particularly preferably, the above allylated phenol resin (ingredient (A)) contains the above structural unit (1) in an amount of 10 to 100% by weight based on the whole ingredient (A).

The phenolic hydroxyl group equivalent (phenol number) of the above allylated phenol resin (ingredient (A)) is preferably in the range of 100 to 3,000 (g/eq.), more preferably from 100 to 1,000 (g/eq.), and particularly preferably from 100 to 500 (g/eq.). The reasons for this are as follows. In the case where the phenolic hydroxyl group equivalent is too small, there is a tendency that the breaking elongation is difficult to increase, which may be caused by increased density of crosslinked points of the cured product. On the other hand, in the case where the phenolic hydroxyl group equivalent is too large, there is a tendency that curability decreases.

Further, the allyl group equivalent (allyl number) of the above allylated phenol resin (ingredient (A)) is preferably in the range of 100 to 3,000 (g/eq.), more preferably in the range of 100 to 2,000 (g/eq.), and particularly preferably in the range of 100 to 1,000 (g/eq.). The reasons for this are as follows. In the case where the above allyl group equivalent is too small departing from the above range, there is a tendency that the breaking elongation is unfavorably difficult to increase, which may be caused by increased density of crosslinked points of the cured product obtained. On the other hand, in the case where the above allyl group equivalent is too large departing from the above range, there is a tendency that heat resistance deteriorates.

The above allylated phenol resin (ingredient (A)) can be synthesized, for example, in the following manner. That is to say, an allyletherified phenol resin is obtained by mixing a phenol resin, an allyl halide, a basic compound and a solvent, and stirring them under heating. Subsequently, the resulting allyletherified phenol resin is heated at a temperature of 180 to 200°C, whereby a part or the whole of allyl groups of the allyletherified phenol resin undergo the Claisen rearrangement. Thus, the desired allylated phenol resin (ingredient (A)) can be synthesized thereby. Further, the desired allylated phenol resin can also be similarly synthesized by mixing ortho-allylphenol and formalin and stirring them under heating. The allylated phenol resin thus synthesized is a phenol resin containing the above structural unit (1) and further the structural unit (2) in some cases, as described above.

The above allylated phenol resins (ingredient (A)) include, for example, phenol-novolac type, triphenylmethane type, diphenylmethane type and furan ring-containing dicyclopentadiene-novolac type phenol resins. These may be used either alone or as a combination of two or more thereof.

As the epoxy resin (ingredient (B)) used in combination with the above ingredient (A), a polyfunctional epoxy resin is preferably used. Examples thereof include phenol-novolac type, cresol-novolac type, triphenylmethane type, diphenylmethane type and furan ring-containing dicyclopentadiene-novolac type epoxy resins. These may be used either alone or as a combination of two or more thereof.

The epoxy equivalent (epoxy number) of the above epoxy resin (ingredient (B)) is preferably in the range of 100 to 3,000 (g/eq.), more preferably in the range of 100 to 1,000 (g/eq.), and particularly preferably in the range of 100 to 500 (g/eq.). That is to say, in the case where the above epoxy equivalent is too small departing from the above range, there is a tendency that the breaking elongation is unfavorably difficult to increase, which may be caused by increased density of crosslinked points of the cured product. On the other hand, in the case where the epoxy equivalent is too large departing from the above range, there is a tendency that curability deteriorates.

For the compounding ratio of the above allylated phenol resin (ingredient (A)) and the epoxy resin (ingredient (B)), the epoxy equivalent of the ingredient (B) is preferably set to the range of 0.5 to 3.0 equivalents based on one equivalent of the phenolic hydroxyl groups of the ingredient (A), from the viewpoint of reactivity thereof. Then, from the viewpoint of the above reactivity, the epoxy equivalent of the ingredient (B) is more preferably set to the range of 0.6 to 2.0 equivalents, and particularly preferably to the range of 0.8 to 1.5 equivalents.

The curing accelerators (ingredient (C)) used in combination with the above ingredient (A) and ingredient (B) include, for example, amine-based curing accelerators, imidazole-based curing accelerators, organophosphorus curing accelerators, boron-based curing accelerators, phosphorus-boron-based curing accelerators and the like. These may be used either alone or as a combination of two or more thereof. Above all, organophosphorus curing accelerators and imidazole-based curing accelerators are preferably used in terms of general versatility in the market and cost.

The content of the above curing accelerator (ingredient (C)) is preferably in the range of 0.01 to 10% by weight based on the total content of the above ingredient (A) and ingredient (B), and more preferably in the range of 0.05 to 5% by weight. The reasons for this are as follows. In the case where the content of the above curing accelerator (ingredient (C)) is too small departing from the above range, there is a tendency that curability deteriorates. On the other hand, in the case where the content of the above curing accelerator (ingredient (C)) is too large departing from the above range, there is a tendency of leading to deterioration of electric characteristics or a decrease in heat resistance.

The thermosetting resin composition according to the invention may suitably contain a catalyst, a filler, a reinforcing material, a flame retardant, a releasing agent, a coupling agent, a plasticizer, a curing assistant, a coloring agent, a flexibilizing agent, a solvent or the like, in addition to the above ingredients (A) to (C), as needed, within the range not impairing the effects of the invention.

The cured product obtained by the method for producing a cured product of a thermosetting resin composition according to the invention contains the allylated phenol resin (ingredient (A)), so that it is a cured product in which the allyl groups are positively cured. As described above, in the curing reaction of the thermosetting resin composition containing the allylated phenol resin (ingredient (A)), the epoxy resin (ingredient (B)) and the curing accelerator (ingredient (C)), a curing reaction due to epoxy-phenol curing occurs by heating at 100 to 200°C as a first-stage reaction process, and the allyl groups having resistance to pyrolysis are cured by heating at 220 to 350°C as a second-stage reaction process, thereby obtaining the cured product. In the invention, pyrolysis of the cured product is inhibited by the curing reaction of the allyl groups to realize improvement in glass transition temperature. For example, when the allyletherified phenol resin in which the Claisen rearrangement has partially proceeded is heated under conditions of 200°C for 100 hours, the Claisen rearrangement proceeds in allylether group moieties, and the allyl group is rearranged to at least one of the ortho- and para-positions of the phenolic hydroxyl group. However, no curing reaction proceeds at all.

When the cured product is prepared by the method for producing a cured product of a thermosetting resin composition according to the invention, it is necessary to conduct the reaction at a temperature of 100 to 200°C, preferably at a temperature of 150 to 200°C, in order to perform pre-curing, in view of moldability in transfer molding, sheet molding, compression molding, screen printing, dispense molding and the like. Further, the reaction time at the above temperature is from 1 to 60 minutes, more preferably from 1 to 30 minutes, and particularly preferably from 1 to 10 minutes. Further, in order to accelerate the curing reaction of the allyl groups, after the reaction is conducted under the above conditions, heating is performed at 220 to 350°C for 10 to 6,000 minutes, particularly preferably at 220 to 300°C for 10 to 1,440 minutes, thereby inhibiting pyrolysis, which makes it possible to obtain the cured product having high glass transition temperature. In the case where the above temperature is too low departing from the above range, it becomes difficult that the allyl groups sufficiently react, so that there is a concern that improvement in heat resistance and glass transition temperature is adversely affected. This is therefore unfavorable. On the other hand, the above-temperature is too high departing from the above range, there is a concern that pyrolysis of the cured product leads to deterioration of heat resistance.

Further, even when a crosslinked structure of the cured product obtained by curing the thermosetting resin composition under long-term high temperature conditions is partially severed by allowing the curing reaction to gradually proceed under a use environment of a semiconductor device at high temperature (for example, 200 to 250°C), the above allyl groups repair the crosslinked structure to impart long-term heat resistance. As for the pyrolysis of the above cured product, for example, the weight loss is preferably 10% by weight or less, more preferably 7.5% by weight or less and still more preferably 5% by weight or less, under conditions of 250°C for 1,000 hours. That is to say, in the case where the weight loss by the pyrolysis of the above cured product is too large departing from the above range, there is a concern that it causes the occurrence of cracks or voids to lead to a failure of the semiconductor device, for example, when the cured product is used as a semiconductor encapsulating material. Incidentally, the weight loss in the pyrolysis of the above cured product is measured and calculated, for example, in the following manner. That is to say, a predetermined amount of the thermosetting resin composition is prepared, cured by heating at 175°C for 5 minutes, and thereafter heated under post-curing conditions (at 220 to 350°C for 10 to 6,000 minutes) to prepare the cured product by a post-curing reaction. Subsequently, after the above cured product is allowed to stand at 250°C for 1,000 hours, the weight thereof is measured, and the rate of the weight loss thereof is calculated.

The production method of the invention includes blending and mixing the allylated phenol resin (ingredient (A)), the epoxy resin (ingredient (B)) and the curing accelerator (ingredient (C)) so as to become predetermined contents, then, first heating the resulting composition at a temperature of 100 to 200°C for 1 to 60 minutes, and thereafter, further heating it at a temperature of 220 to 350°C for 10 to 6,000 minutes, thereby curing the thermosetting resin composition to prepare the cured product.

The cured product obtained by the production method of the invention is particularly excellent in heat resistance, so that it is suitably used, for example, in electronic materials such as electronic parts, laminates for printed-wiring boards and printed-wiring boards, semiconductor encapsulating materials and semiconductor-mounted modules, automobiles and vehicles, aircraft parts, building components, machine tools and the like.

### EXAMPLES

Examples of the invention will be described below together with Comparative Examples. However, the invention should not be construed as being limited to these Examples. Incidentally, "parts" and "%" in Examples are defined as "parts by weight" and "% by weight" respectively, unless otherwise specified.

First, prior to the preparation of thermosetting resin compositions, allylated phenol resins were synthesized (Synthesis Examples A-1 to A-5).

### [Synthesis Example A-1]

A phenol resin (GS-180, manufactured by Gunei Chemical Industry Co., Ltd., phenol equivalent: 105 g/eq.) (105 parts), 181.5 parts of allyl bromide (manufactured by Tokyo Chemical Industry Co., Ltd.), 207.3 parts of potassium carbonate (manufactured by Wako Pure Chemical Industries, Ltd.) and 500 parts of acetone (manufactured by Wako Pure Chemical Industries, Ltd.) were mixed, and refluxed under heating for 24 hours in a nitrogen gas stream. After cooling to room temperature (25 °C), filtration and concentration were performed, and 400 parts of ethyl acetate (manufactured by Wako Pure Chemical Industries, Ltd.) was added to a residue, followed by washing once with 200 parts of a 5% solution of hydrochloric acid (manufactured by Wako Pure Chemical Industries, Ltd.) diluted with distilled water and washing twice with 200-part portions of distilled water. Thereafter, an organic layer was extracted and dried with magnesium sulfate (manufactured by Wako Pure Chemical Industries, Ltd.), followed by filtration and concentration to obtain an allyletherified phenol resin (APN-1) having an allylation ratio of 100%. Subsequently, APN-1 thus obtained was stirred under heating at 200°C for 24 hours in a nitrogen gas atmosphere to synthesize a desired allylated phenol resin (APC-1) having a Claisen rearrangement ratio of 90% and having the above structural units (1) and (2).

### [Synthesis Example A-2]

A phenol resin (GS-180, manufactured by Gunei Chemical Industry Co., Ltd., phenol equivalent: 105 g/eq.) (105 parts), 90.7 parts of allyl bromide (manufactured by Tokyo Chemical Industry Co., Ltd.), 138.2 parts of potassium carbonate (manufactured by Wako Pure Chemical Industries, Ltd.) and 500 parts of acetone (manufactured by Wako Pure Chemical Industries, Ltd.) were mixed, and refluxed under heating for 24 hours in a nitrogen gas stream. After cooling to room temperature (25°C), filtration and concentration were performed, and 400 parts of ethyl acetate (manufactured by Wako Pure Chemical Industries, Ltd.) was added to a residue, followed by washing once with 200 parts of a 5% solution of hydrochloric acid (manufactured by Wako Pure Chemical Industries, Ltd.) diluted with distilled water and washing twice with 200-part portions of distilled water. Thereafter, an organic layer was extracted and dried with magnesium sulfate (manufactured by Wako Pure Chemical Industries, Ltd.), followed by filtration and concentration to obtain an allyletherified phenol resin (APN-2) having an allylation ratio of 64.9%. Subsequently, APN-2 thus obtained was stirred under heating at 200°C for 24 hours in a nitrogen gas atmosphere to synthesize a desired allylated phenol resin (APC-2) having a Claisen rearrangement ratio of 100% and having the above structural units (1) and (2).

### [Synthesis Example A-3]

A phenol resin (GS-180, manufactured by Gunei Chemical Industry Co., Ltd., phenol equivalent: 105 g/eq.) (105 parts), 60.5 parts of allyl bromide (manufactured by Tokyo Chemical Industry Co., Ltd.), 103.7 parts of potassium carbonate (manufactured by Wako Pure Chemical Industries, Ltd.) and 500 parts of acetone (manufactured by Wako Pure Chemical Industries, Ltd.) were mixed, and refluxed under heating for 24 hours in a nitrogen gas stream. After cooling to room temperature (25 °C), filtration and concentration were performed, and 400 parts of ethyl acetate (manufactured by Wako Pure Chemical Industries, Ltd.) was added to a residue, followed by washing once with 200 parts of a 5% solution of hydrochloric acid (manufactured by Wako Pure Chemical Industries, Ltd.) diluted with distilled water and washing twice with 200-part portions of distilled water. Thereafter, an organic layer was extracted and dried with magnesium sulfate (manufactured by Wako Pure Chemical Industries, Ltd.), followed by filtration and concentration to obtain an allyletherified phenol resin (APN-3) having an allylation ratio of 43.3%. Subsequently, APN-3 thus obtained was stirred under heating at 200°C for 24 hours in a nitrogen gas atmosphere to synthesize a desired allylated phenol resin (APC-3) having a Claisen rearrangement ratio of 100% and having the above structural units (1) and (2).

### [Synthesis Example A-4]

A phenol resin (GS-180, manufactured by Gunei Chemical Industry Co., Ltd., phenol equivalent: 105 g/eq.) (105 parts), 30.3 parts of allyl bromide (manufactured by Tokyo Chemical Industry Co., Ltd.), 69.1 parts of potassium carbonate (manufactured by Wako Pure Chemical Industries, Ltd.) and 500 parts of acetone (manufactured by Wako Pure Chemical Industries, Ltd.) were mixed, and refluxed under heating for 24 hours in a nitrogen gas stream. After cooling to room temperature (25°C), filtration and concentration were performed, and 400 parts of ethyl acetate (manufactured by Wako Pure Chemical Industries, Ltd.) was added to a residue, followed by washing once with 200 parts of a 5% solution of hydrochloric acid (manufactured by Wako Pure Chemical Industries, Ltd.) diluted with distilled water and washing twice with 200-part portions of distilled water. Thereafter, an organic layer was extracted and dried with magnesium sulfate (manufactured by Wako Pure Chemical Industries, Ltd.), followed by filtration and concentration to obtain an allyletherified phenol resin (APN-4) having an allylation ratio of 21.5%. Subsequently, APN-4 thus obtained was stirred under heating at 200°C for 24 hours in a nitrogen gas atmosphere to synthesize a desired allylated phenol resin (APC-4) having a Claisen rearrangement ratio of 100% and having the above structural units (1) and (2).

### [Synthesis Example A-5]

A phenol resin (GS-180, manufactured by Gunei Chemical Industry Co., Ltd., phenol equivalent: 105 g/eq.) (105 parts), 12.1 parts of allyl bromide (manufactured by Tokyo Chemical Industry Co., Ltd.), 34.6 parts of potassium carbonate (manufactured by Wako Pure Chemical Industries, Ltd.) and 500 parts of acetone (manufactured by Wako Pure Chemical Industries, Ltd.) were mixed, and refluxed under heating for 24 hours in a nitrogen gas stream. After cooling to room temperature (25°C), filtration and concentration were performed, and 400 parts of ethyl acetate (manufactured by Wako Pure Chemical Industries, Ltd.) was added to a residue, followed by washing once with 200 parts of a 5% solution of hydrochloric acid (manufactured by Wako Pure Chemical Industries, Ltd.) diluted with distilled water and washing twice with 200-part portions of distilled water. Thereafter, an organic layer was extracted and dried with magnesium sulfate (manufactured by Wako Pure Chemical Industries, Ltd.), followed by filtration and concentration to obtain an allyletherified phenol resin (APN-5) having an allylation ratio of 9.5%. Subsequently, APN-5 thus obtained was stirred under heating at 200°C for 24 hours in a nitrogen gas atmosphere to synthesize a desired allylated phenol resin (APC-5) having a Claisen rearrangement ratio of 100% and having the above structural units (1) and (2).

On the other hand, respective ingredients shown below were prepared.

### [Epoxy Resin]

EPPN-501HY (epoxy equivalent: 169 g/eq., manufactured by Nippon Kayaku Co., Ltd.)

### [Curing Accelerator]

TPP (triphenylphosphine, manufactured by Tokyo Chemical Industry Co., Ltd.)

### [Examples 1 to 15]

Using the allylated phenol resins (APC-1, APC-2, APC-3, APC-4 and APC-5) obtained in the above Synthesis Examples A-1 to A-5 as phenol resins, the epoxy resin and the curing accelerator (triphenylphosphine), thermosetting resin compositions were prepared by blending and mixing them in the compounding ratios shown in Tables 1 to 3 given later. Then, the above thermosetting resin compositions were cured by heating at 175°C for 5 minutes, and thereafter, further heated under the post-curing conditions (predetermined temperature and predetermined time) shown in Tables 1 to 3 given later to perform post-curing, thereby preparing cured products of the thermosetting resin compositions.

### [Comparative Examples 1 to 5]

Using the allyl group-free phenol resin (GS-180, phenolic hydroxyl group equivalent: 105 g/eq., manufactured by Gunei Chemical Industry Co., Ltd.) as a phenol resin, the epoxy resin and the curing accelerator (triphenylphosphine), thermosetting resin compositions were prepared by blending and mixing them in the compounding ratios shown in Table 4 given later. Then, the above thermosetting resin compositions were cured by heating at 175°C for 5 minutes, and thereafter, further heated under the post-curing conditions (predetermined temperature and predetermined time) shown in Table 4 given later to perform post-curing, thereby preparing cured products of the thermosetting resin compositions.

### [Comparative Examples 6 to 15]

Using the allylated phenol resins (APC-1, APC-2, APC-3, APC-4 and APC-5) obtained in the above Synthesis Examples A-1 to A-5 as phenol resins, the epoxy resin and the curing accelerator (triphenylphosphine), thermosetting resin compositions were prepared by blending and mixing them in the compounding ratios shown in Tables 5 and 6 given later. Then, the above thermosetting resin compositions were cured by heating at 175°C for 5 minutes, and thereafter, further heated under the post-curing conditions (predetermined temperature and predetermined time) shown in Tables 5 and 6 given later to perform post-curing, thereby preparing cured products of the thermosetting resin compositions.

Using the thermosetting resin compositions thus obtained and the cured products thereof, characteristics (glass transition temperature, dynamic viscoelasticity and long-term heat resistance) were measured and evaluated by the following methods. The results thereof are also shown in Tables 1 to 6 given later.

### [Long-Term Heat Resistance]

About 2 g of each of the above thermosetting resin compositions was put in an aluminum cup, and the thermosetting resin composition sample put in the aluminum cup was placed on a hot plate set to 175°C, followed by curing by heating for 5 minutes. Thereafter, the sample was heated under the post-curing conditions (predetermined temperature and predetermined time) shown in Tables 1 to 6 to perform post-curing. The cured product sample which underwent the above series of curing processes was put in a hot-air oven set to 250°C, and 1,000-hour long-term heat resistance was evaluated according to the following criteria:
Excellent: the weight loss ratio at 250°C for 1,000 hours was 5% or less.
Good: the weight loss ratio at 250°C for 1,000 hours was from more than 5% to 7.5%.
Fair: the weight loss ratio at 250°C for 1,000 hours was from more than 7.5% to 10%.
Poor: the weight loss ratio at 250°C for 1,000 hours was more than 10%.

### [Glass Transition Temperature]

Cured product samples (2 mm in thickness, 5 mm in width and 20 mm in length) were prepared under the same conditions (curing by heating at 175°C for 5 minutes and the post-curing conditions shown in Tables 1 to 6) as in the above long-term heat resistance evaluation, and the glass transition temperature was measured using a dynamic viscoelasticity measuring device (manufactured by SII Nano Technology Inc.). From the data obtained, the temperature at the maximum peak value of tanD was taken as the glass transition temperature (°C).

### [Dynamic Viscoelasticity]

Cured product samples (2 mm in thickness, 5 mm in width and 20 mm in length) were prepared under the same conditions (curing by heating at 175°C for 5 minutes and the post-curing conditions shown in Tables 1 to 6) as in the above long-term heat resistance evaluation, and the glass transition temperature was measured using a dynamic viscoelasticity measuring device (manufactured by SII Nano Technology Inc.). From the data obtained, the values of the storage elastic modulus (E') at 25°C and 200°C were taken as the dynamic viscoelasticity at the respective temperatures.

**Table 1**

| (parts) | | | | | | |
|---|---|---|---|---|---|---|
| | | Example | | | | |
| | | 1 | 2 | 3 | 4 | 5 |
| Allylated Phenol Resin | | 48.7 (APC-1) | 43.7 (APC-2) | 42.0 (APC-3) | 40.2 (APC-4) | 39.2 (APC-5) |
| Epoxy Resin | | 51.3 | 56.3 | 58.0 | 59.8 | 60.8 |
| Curing Accelerator (TPP) | | 1 | 1 | 1 | 1 | 1 |
| | | | | | | |
| Allylation ratio (%) | | 100 | 64.9 | 43.3 | 21.5 | 100 |
| Claisen rearrangement ratio (%) | | 90 | 100 | 100 | 100 | 90 |
| Phenol Number (g/eq.) | | 160.4 | 131.0 | 122.3 | 113.6 | 108.8 |
| Allyl Number (g/eq.) | | 145.0 | 201.8 | 282.5 | 528.4 | 1145.3 |
| Epoxy Number (g/eq.) | | 169 | 169 | 169 | 169 | 169 |
| Epoxy equivalent/ Phenolic hydroxyl group equivalent | | 1.0 | 1.0 | 1.0 | 1.0 | 1.0 |
| Post-Curing Conditions* | | E | E | E | E | E |
| | | | | | | |
| Glass Transition Temperature (°C) | | 213 | 245 | 239 | 180 | 170 |
| Dynamic | 25°C | 3780 | 3370 | 3780 | 3630 | 3220 |
| Viscoelasticity (MPa) | 200°C | 1610 | 1700 | 1560 | 228 | 122 |
| Long-Term Heat Resistance | | Excellent | Excellent | Excellent | Good | Fair |

| | | | | | | |
|---|---|---|---|---|---|---|
| * A: at 175°C for 10 hours B: at 200°C for 100 hours C: at 220°C for 100 hours D: at 250°C for 10 hours E: at 300°C for 5 hours | | | | | | |

**Table 2**

| (parts) | | | | | | |
|---|---|---|---|---|---|---|
| | | Example | | | | |
| | | 6 | 7 | 8 | 9 | 10 |
| Allylated Phenol Resin | | 48.7 (APC-1) | 43.7 (APC-2) | 42.0 (APC-3) | 40.2 (APC-4) | 39.2 (APC-5) |
| Epoxy Resin | | 51.3 | 56.3 | 58.0 | 59.8 | 60.8 |
| Curing Accelerator (TPP) | | 1 | 1 | 1 | 1 | 1 |
| | | | | | | |
| Allylation ratio (%) | | 100 | 64.9 | 43.3 | 21.5 | 100 |
| Claisen rearrangement ratio (%) | | 90 | 100 | 100 | 100 | 90 |
| Phenol Number (g/eq.) | | 160.4 | 131.0 | 122.3 | 113.6 | 108.8 |
| Allyl Number (g/eq.) | | 145.0 | 201.8 | 282.5 | 528.4 | 1145.3 |
| Epoxy Number (g/eq.) | | 169 | 169 | 169 | 169 | 169 |
| Epoxy equivalent/ Phenolic hydroxyl group equivalent | | 1.0 | 1.0 | 1.0 | 1.0 | 1.0 |
| Post-Curing Conditions* | | D | D | D | D | D |
| | | | | | | |
| Glass Transition Temperature (°C) | | 201 | 206 | 187 | 172 | 159 |
| Dynamic | 25°C | 3650 | 3470 | 2510 | 3510 | 3260 |
| Viscoelasticity (MPa) | 200°C | 1030 | 754 | 139 | 148 | 114 |
| Long-Term Heat Resistance | | Excellent | Excellent | Excellent | Good | Fair |

| | | | | | | |
|---|---|---|---|---|---|---|
| * A: at 175°C for 10 hours B: at 200°C for 100 hours C: at 220°C for 100 hours D: at 250°C for 10 hours E: at 300°C for 5 hours | | | | | | |

**Table 3**

| (parts) | | | | | | |
|---|---|---|---|---|---|---|
| | | Example | | | | |
| | | 11 | 12 | 13 | 14 | 15 |
| Allylated Phenol Resin | | 48.7 (APC-1) | 43.7 (APC-2) | 42.0 (APC-3) | 40.2 (APC-4) | 39.2 (APC-5) |
| Epoxy Resin | | 51.3 | 56.3 | 58.0 | 59.8 | 60.8 |
| Curing Accelerator (TPP) | | 1 | 1 | 1 | 1 | 1 |
| | | | | | | |
| Allylation ratio (%) | | 100 | 64.9 | 43.3 | 21.5 | 100 |
| Claisen rearrangement ratio (%) | | 90 | 100 | 100 | 100 | 90 |
| Phenol Number (g/eq.) | | 160.4 | 131.0 | 122.3 | 113.6 | 108.8 |
| Allyl Number (g/eq.) | | 145.0 | 201.8 | 282.5 | 528.4 | 1145.3 |
| Epoxy Number (g/eq.) | | 169 | 169 | 169 | 169 | 169 |
| Epoxy equivalent/ Phenolic hydroxyl group equivalent | | 1.0 | 1.0 | 1.0 | 1.0 | 1.0 |
| Post-Curing Conditions* | | C | C | C | C | C |
| | | | | | | |
| Glass Transition Temperature (°C) | | 179 | 182 | 174 | 170 | 162 |
| Dynamic | 25°C | 3790 | 3490 | 2890 | 3170 | 2630 |
| Viscoelasticity (MPa) | 200°C | 348 | 320 | 276 | 198 | 158 |
| Long-Term Heat Resistance | | Excellent | Excellent | Good | Fair | Fair |

| | | | | | | |
|---|---|---|---|---|---|---|
| * A: at 175°C for 10 hours B: at 200°C for 100 hours C: at 220°C for 100 hours D: at 250°C for 10 hours E: at 300°C for 5 hours | | | | | | |

**Table 4**

| (parts) | | | | | | |
|---|---|---|---|---|---|---|
| | | Comparative Example | | | | |
| | | 1 | 2 | 3 | 4 | 5 |
| Phenol Resin | | 38.3 (GS-180) | 38.3 (GS-180) | 38.3 (GS-180) | 38.3 (GS-180) | 38.3 (GS-180) |
| Epoxy Resin | | 61.7 | 61.7 | 61.7 | 61.7 | 61.7 |
| Curing Accelerator (TPP) | | 1 | 1 | 1 | 1 | 1 |
| | | | | | | |
| Allylation ratio (%) | | 0 | 0 | 0 | 0 | 0 |
| Claisen rearrangement ratio (%) | | - | - | - | - | - |
| Phenol Number (g/eq.) | | 105 | 105 | 105 | 105 | 105 |
| Allyl Number (g/eq.) | | 0 | 0 | 0 | 0 | 0 |
| Epoxy Number (g/eq.) | | 169 | 169 | 169 | 169 | 169 |
| Epoxy equivalent/ Phenolic hydroxyl group equivalent | | 1.0 | 1.0 | 1.0 | 1.0 | 1.0 |
| Post-Curing Conditions* | | A | B | C | D | E |
| | | | | | | |
| Glass Transition Temperature (°C) | | 156 | 155 | 154 | 162 | 158 |
| Dynamic | 25°C | 2740 | 3430 | 2920 | 3100 | 3620 |
| Viscoelasticity (MPa) | 200°C | 156 | 138 | 108 | 119 | 173 |
| Long-Term Heat Resistance | | Poor | Poor | Poor | Poor | Poor |

| | | | | | | |
|---|---|---|---|---|---|---|
| * A: at 175°C for 10 hours B: at 200°C for 100 hours C: at 220°C for 100 hours D: at 250°C for 10 hours E: at 300°C for 5 hours | | | | | | |

**Table 5**

| (parts) | | | | | | |
|---|---|---|---|---|---|---|
| | | Comparative Example | | | | |
| | | 6 | 7 | 8 | 9 | 10 |
| Allylated Phenol Resin | | 48.7 (APC-1) | 43.7 (APC-2) | 42.0 (APC-3) | 40.2 (APC-4) | 39.2 (APC-5) |
| Epoxy Resin | | 51.3 | 56.3 | 58.0 | 59.8 | 60.8 |
| Curing Accelerator (TPP) | | 1 | 1 | 1 | 1 | 1 |
| | | | | | | |
| Allylation ratio (%) | | 100 | 64.9 | 43.3 | 21.5 | 100 |
| Claisen rearrangement ratio (%) | | 90 | 100 | 100 | 100 | 90 |
| Phenol Number (g/eq.) | | 160.4 | 131.0 | 122.3 | 113.6 | 108.8 |
| Allyl Number (g/eq.) | | 145.0 | 201.8 | 282.5 | 528.4 | 1145.3 |
| Epoxy Number (g/eq.) | | 169 | 169 | 169 | 169 | 169 |
| Epoxy equivalent/ Phenolic hydroxyl group equivalent | | 1.0 | 1.0 | 1.0 | 1.0 | 1.0 |
| Post-Curing Conditions* | | A | A | A | A | A |
| | | | | | | |
| Glass Transition Temperature (°C) | | 146 | 140 | 126 | 106 | 136 |
| Dynamic | 25°C | 2730 | 2770 | 3230 | 2610 | 2980 |
| Viscoelasticity (MPa) | 200°C | 60 | 4.7 | 4.1 | 2.8 | 12 |
| Long-Term Heat Resistance | | Fair | Fair | Fair | Fair | Poor |

| | | | | | | |
|---|---|---|---|---|---|---|
| * A: at 175°C for 10 hours B: at 200°C for 100 hours C: at 220°C for 100 hours D: at 250°C for 10 hours E: at 300°C for 5 hours | | | | | | |

**Table 6**

| (parts) | | | | | | |
|---|---|---|---|---|---|---|
| | | Comparative Example | | | | |
| | | 11 | 12 | 13 | 14 | 15 |
| Allylated Phenol Resin | | 48.7 (APC-1) | 43.7 (APC-2) | 42.0 (APC-3) | 40.2 (APC-4) | 39.2 (APC-5) |
| Epoxy Resin | | 51.3 | 56.3 | 58.0 | 59.8 | 60.8 |
| Curing Accelerator (TPP) | | 1 | 1 | 1 | 1 | 1 |
| | | | | | | |
| Allylation ratio (%) | | 100 | 64.9 | 43.3 | 21.5 | 100 |
| Claisen rearrangement ratio (%) | | 90 | 100 | 100 | 100 | 90 |
| Phenol Number (g/eq.) | | 160.4 | 131.0 | 122.3 | 113.6 | 108.8 |
| Allyl Number (g/eq.) | | 145.0 | 201.8 | 282.5 | 528.4 | 1145.3 |
| Epoxy Number (g/eq.) | | 169 | 169 | 169 | 169 | 169 |
| Epoxy equivalent/ Phenolic hydroxyl group equivalent | | 1.0 | 1.0 | 1.0 | 1.0 | 1.0 |
| Post-Curing Conditions* | | B | B | B | B | B |
| | | | | | | |
| Glass Transition Temperature (°C) | | 154 | 140 | 127 | 108 | 130 |
| Dynamic | 25°C | 2960 | 2680 | 3500 | 3520 | 2880 |
| Viscoelasticity (MPa) | 200°C | 85 | 158 | 10 | 6.5 | 11 |
| Long-Term Heat Resistance | | Excellent | Good | Good | Fair | Fair |

| | | | | | | |
|---|---|---|---|---|---|---|
| * A: at 175°C for 10 hours B: at 200°C for 100 hours C: at 220°C for 100 hours D: at 250°C for 10 hours E: at 300°C for 5 hours | | | | | | |

The above results show that the samples of Examples as the cured products prepared under the specific curing reaction conditions have high glass transition temperature and high dynamic viscoelasticity (25°C and 200°C). Also with regard to long-term heat resistance, the good results are obtained.

On the other hand, the samples of Comparative Examples 1 to 5 as the cured products prepared using the ordinary phenol resin having no allyl group have low glass transition temperature and low dynamic viscoelasticity at 200°C. Moreover, in the evaluation of long-term heat resistance, they have high weight loss ratio, leading to the poor evaluation results with regard to long-term heat resistance.

Further, all the samples of Comparative Examples 6 to 15 as the cured products prepared under the conditions departing from the specific curing reaction conditions have low glass transition temperature and low dynamic viscoelasticity at 200°C. Moreover, in the evaluation of long-term heat resistance, the poor evaluation results are obtained with regard to long-term heat resistance, compared to the samples of Examples, although the weight loss ratio is somewhat suppressed, compared to the samples of Comparative Examples 1 to 5.

Then, there were measured changes in glass transition temperature of the cured products depending on the post-curing conditions at the time when the cured products were prepared (at 175°C for 5 minutes + post-curing) using the allylated phenol resins (APC-1 to APC-5) and the phenol resin (GS-180) and the epoxy resin (EPPN-501HY) at a compounding molar ratio of 50/50. The results thereof are shown in Fig. 1. That is to say, Fig. 1 is a graph showing the changes in glass transition temperature of the cured products depending on the difference in the post-curing conditions, when curing was performed at 175°C for 5 minutes. Incidentally, the glass transition temperature was measured in the same manner as described above. The results show that in the case where the allylated phenol resins are used, the glass transition temperature significantly increases in a high-temperature region of the post-curing temperature, particularly in a high-temperature region of 220°C or more, to provide the cured products having a glass transition temperature exceeding 200°C, even when the epoxy resin has a common skeleton. As contrasted therewith, the results show that in the case where the phenol resin not allylated (GS-180) is used, the glass transition temperature is approximately constant regardless of the post-curing conditions.

While the invention has been described in detail with reference to specific embodiments thereof, it will be apparent to one skilled in the art that various changes and modifications can be made therein without departing from the spirit and scope thereof.
Incidentally, the present application is based on Japanese Patent Application No. 2010-156234 filed on July 8, 2010, and the contents are incorporated herein by reference.
All references cited herein are incorporated by reference herein in their entirety.
Also, all the references cited herein are incorporated as a whole.

The cured product obtained by the method for producing a cured product of a thermosetting resin composition according to the invention has excellent long-term heat resistance and high glass transition temperature which cannot be realized by the conventional thermosetting resin compositions, and is useful as a heat-resistant/insulating resin for electronic materials. The electronic materials include, for example, electronic parts, laminates for printed-wiring boards and printed-wiring boards, semiconductor encapsulating materials, semiconductor-mounted modules and the like. Further, it is also suitably used in automobiles and vehicles, aircraft parts, building components, machine tools and the like.

## Claims

1. A method for producing a cured product of a thermosetting resin composition, said method comprising: heating a thermosetting resin composition comprising the following ingredients (A) to (C) at a temperature of 100 to 200°C for 1 to 60 minutes; and then further heating the thermosetting resin composition at a temperature of 220 to 350°C for 10 to 6,000 minutes, thereby curing the thermosetting resin composition:
(A) an allylated phenol resin;
(B) an epoxy resin; and
(C) a curing accelerator.

2. The method for producing a cured product of a thermosetting resin composition according to claim 1, wherein the allylated phenol resin as ingredient (A) contains the following structural unit (1):

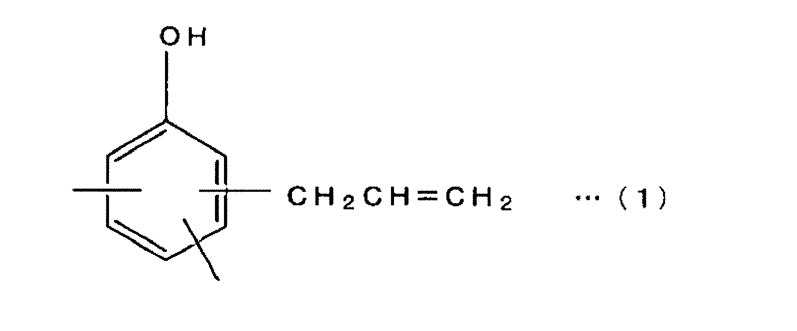

3. The method for producing a cured product of a thermosetting resin composition according to claim 2, wherein the allylated phenol resin as ingredient (A) contains the following structural unit (2), in addition to the structural unit (1):

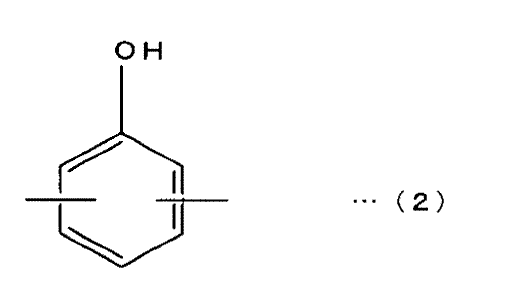

4. The method for producing a cured product of a thermosetting resin composition according to any one of claims 1 to 3, wherein the allylated phenol resin as ingredient (A) has an allyl group equivalent of 100 to 3,000 (g/eq.).

5. The method for producing a cured product of a thermosetting resin composition according to any one of claims 1 to 4, wherein the allylated phenol resin as ingredient (A) has a phenolic hydroxyl group equivalent of 100 to 3,000 (g/eq.).

6. A cured product obtained by the method for producing a cured product of a thermosetting resin composition according to any one of claims 1 to 5.
